(19) Europäisches Patentamt European Patent Office Office européen des brevets

(11) **EP 1 055 934 B1**

(12) **EUROPEAN PATENT SPECIFICATION**

(45) Date of publication and mention of the grant of the patent:
**05.09.2007 Bulletin 2007/36**

(51) Int Cl.:
***G01R 31/36*** *(2006.01)*

(21) Application number: **00109123.0**

(22) Date of filing: **05.05.2000**

(54) **Battery remaining capacity measuring apparatus suitable for hybrid car**

Batterierestkapazitätsmesser für Hybridfahrzeug geeignet

Appareil de mesure de la capacité résiduelle d'une batterie approprié pour un véhicule hybride

(84) Designated Contracting States:
**DE FR GB IT SE**

(30) Priority: **26.05.1999 JP 14720299**

(43) Date of publication of application:
**29.11.2000 Bulletin 2000/48**

(73) Proprietor: **YAZAKI CORPORATION Minato-ku Tokyo 108-8333 (JP)**

(72) Inventors:
• **Arai, Youichi Susono-shi, Shizuoka-ken (JP)**
• **Nagao, Masashi Susono-shi, Shizuoka-ken (JP)**
• **Takemoto, Hisashi Susono-shi, Shizuoka-ken (JP)**

(74) Representative: **HOFFMANN EITLE Patent- und Rechtsanwälte Arabellastrasse 4 81925 München (DE)**

(56) References cited:
**US-A- 5 698 983          US-A- 5 793 211**

**Description**

The present invention relates to a battery remaining capacity measuring apparatus, more particularly to a battery remaining capacity measuring apparatus wherein a quantity of collected samples of battery current and voltage, and a quantity of samples for obtaining an average thereof are determined by a discharging time which changes depending on the kind of a load.

Generally, measurement of the battery remaining capacity of an electric automobile is premised that discharge is continued for at least 10 seconds as shown in Fig.7 by keeping an accelerator pressed, as described in Japanese Patent Application Laid-Open No.H8-62310.

In the battery remaining capacity measuring apparatus disclosed in Japanese Patent Application Laid-Open No.H8-62310, discharge current I and voltage V from the battery are sampled every 1 millisecond, and each time when 100 units (N1) of this current value and voltage value of 1 millisecond are collected, those values are averaged so as to obtain average data. When 100 units (N2) of this average data (N1 × N2 = 10000) are obtained, a correlation between current and voltage is obtained. When a strong negative correlation is indicated, an approximate line (Y = a · X + b Y: current, X: voltage) is obtained based on the 100 average data. Then, by substituting a specified value for Y in this equation, the voltage X is specified so as to regard this voltage as current remaining capacity. That is, the remaining capacity is obtained based on data obtained by measuring for 10 seconds.

Because the quantity of data is very massive, even when current data in a charging direction for a short time exists, this can be buried as an error.

However, recently, a high voltage vehicle called hybrid car or simple hybrid car has been used which contains two kinds of driving sources, namely an engine and a DC motor and is driven by an engine or DC motor.

In such a hybrid car, recharge and discharge to the battery are repeated frequently. Therefore, the quantity of current data in the recharging direction increases so that this cannot be neglected as an error.

Particularly at the time of regenerative charge during a traveling of a vehicle or generative charge with an alternator, charging current to the battery is not constant (constant voltage charge), so that the correlation between current and voltage is reduced.

That is, the aforementioned method in which each time when 100 (N1) data each comprised of current value and voltage value of 1 millisecond are collected, these values are averaged so as to obtain average data and the remaining capacity is obtained with current and voltage when 100 (N2) units (N1 × N2 = 10000) of this average data are obtained, cannot be applied to measurement of the remaining capacity of the hybrid car because the correlation therebetween is small when no specific measure is taken.

Further, the DC motor used in the hybrid car which is a load of the battery varies in type depending on the hybrid car (including a high-voltage vehicle) and further, its discharging period changes. Therefore, when N1 and N2 are specified to be 100, the remaining capacity measuring apparatus cannot be applied to various hybrid cars.

United States patent no. 5,698,983 discloses an apparatus and method for measuring the remaining capacity of a battery connected to a fluctuating load. The apparatus senses dispersive terminal voltages and dispersive discharge currents from the battery, and samples the sensed terminal voltages and discharge currents. On the basis of the sampled terminal voltages and discharge currents, the apparatus calculates a watt-hour value of the battery for a predetermined time interval, and checks whether the calculated watt-hour value reaches a predetermined value. If the calculated watt-hour value reaches the predetermined value, the apparatus calculates an approximate linear function indicative of a trend of the sampled terminal voltages and discharge currents, and calculates a voltage corresponding to a reference discharge current in accordance with the calculated approximate linear function as a remaining capacity voltage. The apparatus then converts the calculated remaining capacity voltage into an ordinate position on a two-dimensional display screen, and a calculated total watt-hour value into an abscissa position on the same display screen, and displays the positions in the form of a dot curve.

According to an aspect of the invention, there is provided a battery remaining capacity measuring apparatus comprising: a voltage sensor for detecting a terminal voltage of a battery connected to a load; a current sensor for detecting a current flowing from the battery to the load; a collecting means for collecting a voltage value detected by the voltage sensor and a current value detected by the current sensor every predetermined time interval; an obtaining means for obtaining plural pairs of voltage values and current values collected by the collecting means in a period in which the battery is continuously discharged, wherein the obtaining means continues to obtain a pair of voltage value and current value when the current value indicates that the battery is in discharging condition and the current value is more than a predetermined value, but stops obtaining the pair of voltage value and current value when otherwise; a computing means for computing a sample correlation coefficient between voltage and current based on the plural pairs of voltage values and current values obtained by the obtaining means, wherein the computing means is configured to compute an approximate line using current-voltage coordinates based on the plural pairs of the voltage values and the current values when the correlation coefficient indicates that a predetermined degree of correlation is exceeded; and an estimating means for estimating a remaining capacity of the battery by obtaining a corresponding voltage value based on the approximate line and a preliminarily set current value.

The nature, principle and utility of the invention will become more apparent from the following detailed description when read in conjunction with the accompanying drawings.

In the accompanying drawings:

Fig. 1 is a schematic structure diagram of a battery controller and its peripherals, according to an embodiment of the invention;

Fig. 2 is a flow chart for explaining an operation of the remaining capacity measuring apparatus;

Fig. 3 is a flow chart for explaining an operation of the remaining capacity measuring apparatus;

Fig. 4 is a wave form diagram obtained by measuring charge and discharge of the battery for a long time;

Fig. 5 is an enlarged wave form diagram obtained by magnifying a discharging portion of the wave form shown in Fig. 4;

Fig. 6 is an explanatory diagram for explaining voltage-current characteristic; and

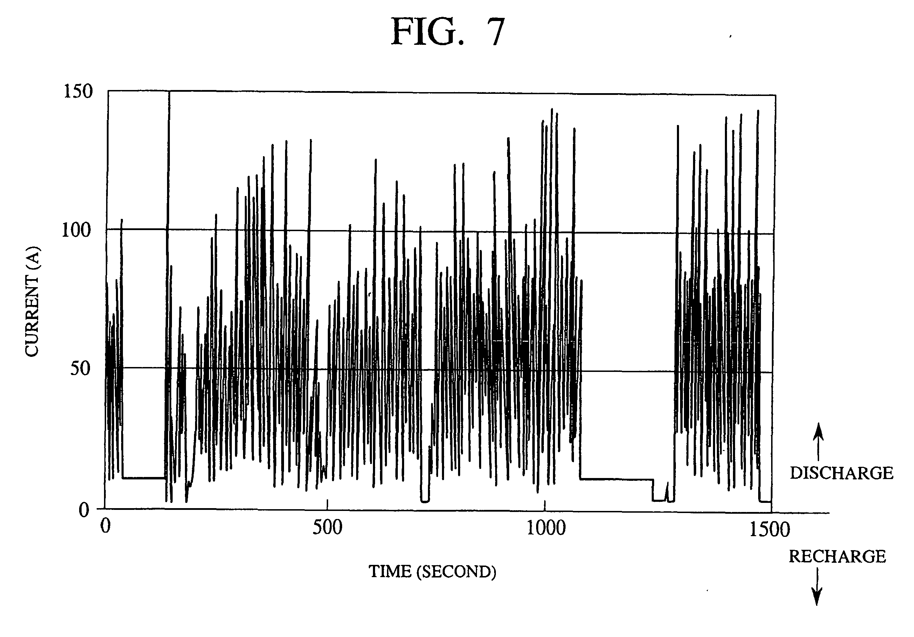

Fig. 7 is a wave form diagram for explaining charge and discharge of the battery of an electric vehicle.

Embodiments of the invention described hereinbelow provide a battery remaining capacity measuring apparatus capable of measuring with high accuracy a remaining capacity of a battery that is provided, for example, in a hybrid car, in which recharge and discharge to the battery are repeated frequently.

Usually, the remaining capacity of a rechargeable battery is measured according to a relation between current value and voltage value at the time of discharge. Meanwhile, the rechargeable battery repeats recharge and discharge depending on its load. Therefore, it is desirable to collect data at the time of discharge selectively to measure the remaining capacity of the battery accurately. An embodiment of the present invention achieves such a requirement. That is, according to collected current value data, whether or not the battery is being discharged is determined and then, a remaining capacity is estimated according to current values and voltage values corresponding to a period in which the battery is being discharged. The remaining capacity of the battery can be measured accurately regardless of the characteristic of the connected load.

Furthermore, the obtaining means described in the following continues to obtain a pair of voltage value and current value when the current value indicates that the battery is in discharging condition and the current value is more than a predetermined value, but stops obtaining the pair of voltage value and current value when otherwise.

The remaining capacity is estimated according to current values and voltage values obtained in a period in which the battery is being discharged, and under the condition that the current values are below a predetermined value in order to increase reliability.

Further, when the quantity of plural pairs of voltage value and current value collected in a period in which the battery is continuously discharged is larger than a maximum value or smaller than a predetermined minimum value, it is preferable that the obtaining means aborts the obtained plural pairs of voltage value and current value.

Although the remaining capacity of the battery is estimated according to current values and voltage values obtained in a period in which the battery is being discharged, when that period is too long or too short, the reliability of the obtained data drops, and therefore, it is preferable that the data obtained in such a case is not adopted as a basis for the estimation of the remaining capacity.

Further, according to another preferred embodiment of the present invention, the load is a hybrid mechanism for assisting travel with an engine and a motor and the battery is electrically connected to the motor.

Particularly in case where the load is a motor in the hybrid mechanism, the battery is discharged and recharged repeatedly and frequently. However, embodiments of the present invention allow the remaining capacity of the battery to be measured accurately.

According to still another preferred embodiment of the present invention, the predetermined value is 10 ampere.

A background example battery remaining capacity measuring apparatus comprises: a voltage sensor for detecting a terminal voltage of a battery connected to a load; a current sensor for detecting a current flowing from the battery to the load; a collecting means for collecting a voltage value detected by the voltage sensor and a current value detected by the current sensor every predetermined time; an obtaining means for obtaining plural pairs of voltage values and current values collected in a period in which the battery is continuously discharged, of plural pairs of voltage values and current values collected by the collecting means; a computing means for computing a correlation value between voltage and current based on the plural pairs of voltage values and current values obtained by the obtaining means; a computing means for when the correlation value indicates a stronger correlation than a predetermined level, computing an approximate line on current-voltage coordinate based on the plural pairs of the voltage values and the current values; and an estimating means for estimating a remaining capacity of the battery by obtaining a corresponding voltage value based on the approximate line and a preliminarily set current value.

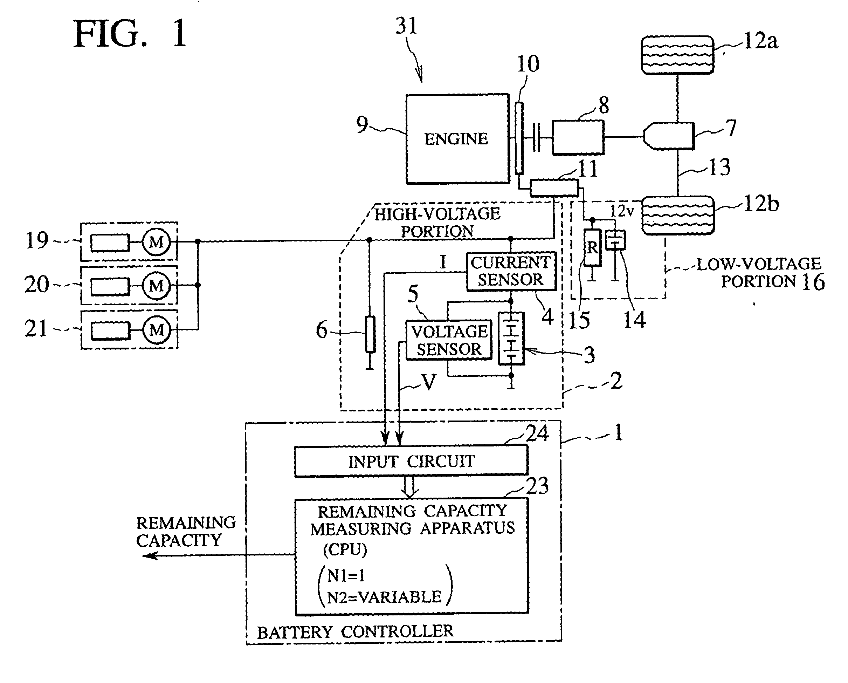

Fig. 1 is a schematic structure diagram of a battery controller and its peripherals according to an embodiment of the invention.

A battery controller 1 shown in Fig. 1 samples current I and voltage V from a current sensor 4 and a voltage sensor 5 respectively, provided in a high-voltage battery 3 included in a high-voltage portion 2 every 1 millisecond. Then, it investigates voltage-current characteristic based on a current value and a voltage value during an interval in which discharge current I is, for example, less than -10A (-10A, -20A, -30A, ...) in order to obtain a remaining capacity.

As shown in Fig. 1, this high-voltage portion 2 is connected to a hybrid mechanism portion 12 comprising a gear box 8 connected to a transmission 7 for transmitting a driving force to tires 12a, 12b via a shaft 13, an engine 9 connected to this gear box 8, a motor/generator 10 provided between the gear box 8 and engine 9 and a converter 11 for supplying a predetermined power to the motor/generator 10 or converting an electric power from the motor/generator 10 to a predetermined power. More specifically, the battery 3 of the high-voltage portion 2 is connected to the converter 11.

A low-voltage portion 16 comprising a battery 14 of 12V and an output resistor 15 for the battery 14 is connected to the converter 11.

Further, the high-voltage portion 2 contains an output resistor 6 for electric power supply and is electrically connected to a wiper 19, a power window 20, an air conditioner 21 and the like.

The battery controller 1 of this embodiment estimates a remaining capacity using current I and voltage V of the high-voltage battery 3 which supplies an electric power to the hybrid mechanism portion 31 for assisting traveling of a vehicle by means of the battery 3 or is recharged with an electric power sent from the hybrid mechanism portion 31.

As shown in Fig. 1, this battery controller 1 comprises an input circuit 24 for detecting charging current and recharging current of the battery 3 and a terminal voltage at the time of discharge/recharge and converting the detected current and detected voltage to a predetermined level and predetermined width and a remaining capacity measuring apparatus 23 for estimating a remaining capacity using the detected current and detected voltage.

The remaining capacity measuring apparatus 23 (computer) samples current I and voltage V of the battery 3 from the input circuit 24 every 1 millisecond. Each time when a single unit (N1) of data comprised of current I and voltage V of 1 millisecond is collected, it is determined that the current I is less than, for example, -10A. When the current is less than -10A, the voltage value and current value are plotted on voltage-current coordinate system and such a processing is continued while the detected current is less than -10A. When the detected current exceeds -10A, a battery remaining capacity is estimated based on the current value data and voltage value data collected in that while. That is, the quantity N2 of pairs of the current data and voltage data which are a basis for estimation of the battery remaining capacity changes depending on the kind of a load.

The remaining capacity is obtained from data plotted on the voltage-current coordinate. That is, a correlation coefficient between current and voltage is obtained according to plural data obtained on this coordinate system. When a strong negative correlation is indicated, an approximate line (Y = a · X + b Y: current, X: voltage) indicating a relation between voltage and current is obtained. By substituting a predetermined value for Y of this equation, the voltage X is specified so that a value corresponding to this voltage is regarded as a current remaining capacity.

When recharge and discharge are repeated, the remaining capacity is measured based on only data obtained during the discharging time which changes depending on the characteristic of a load.

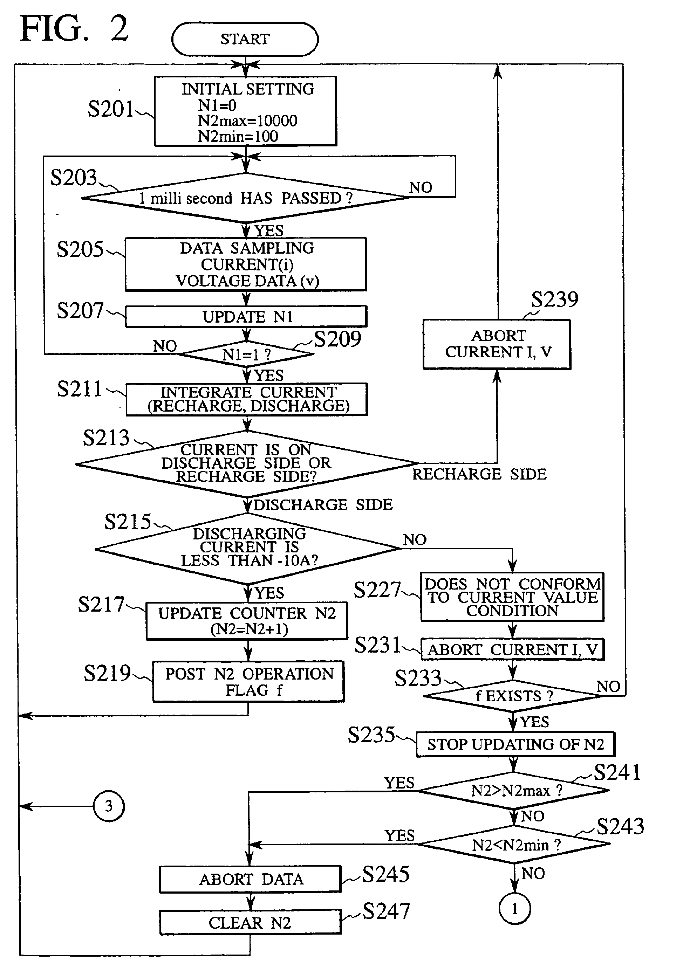

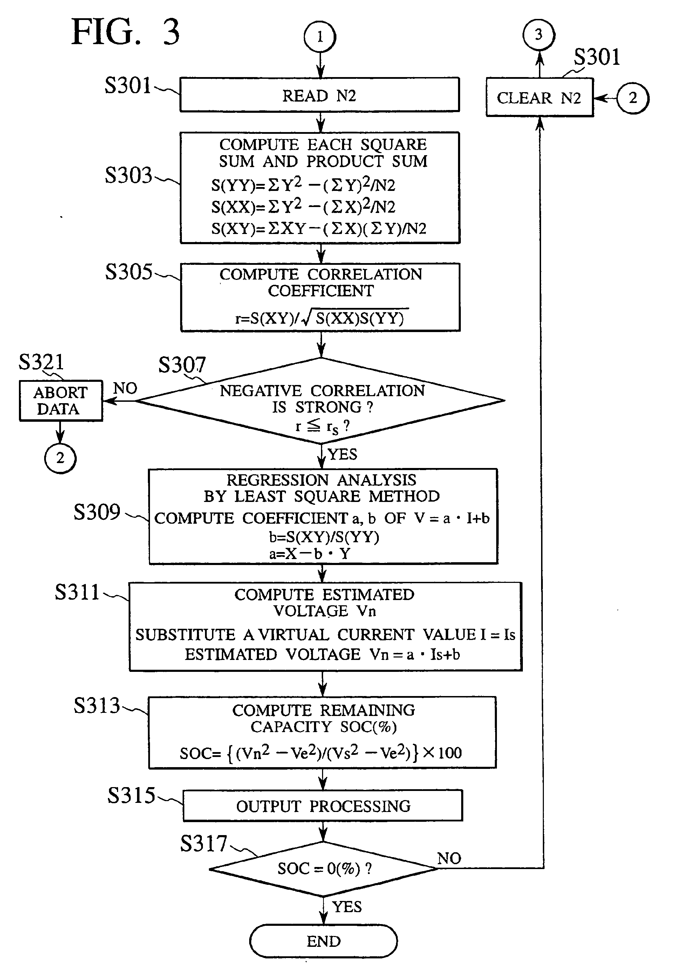

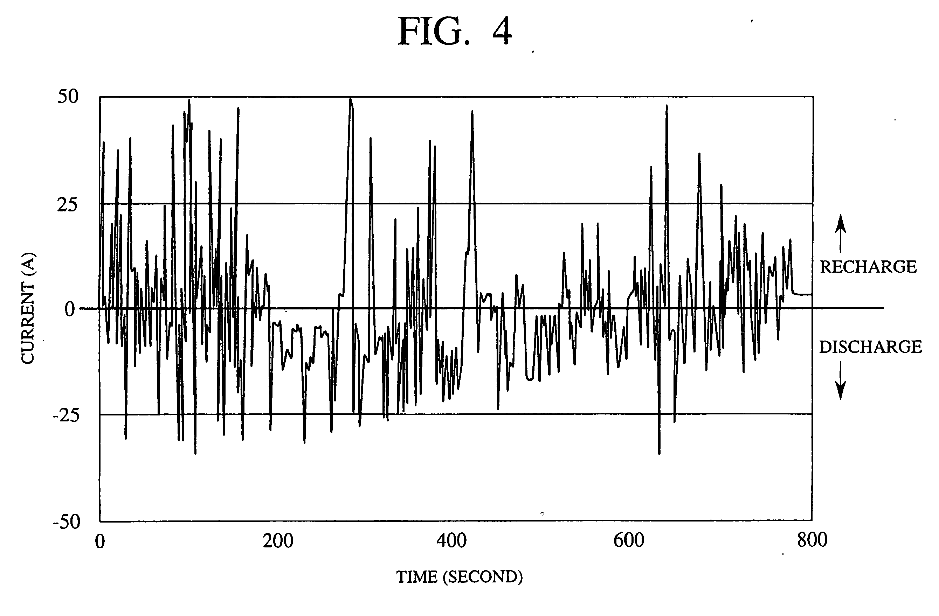

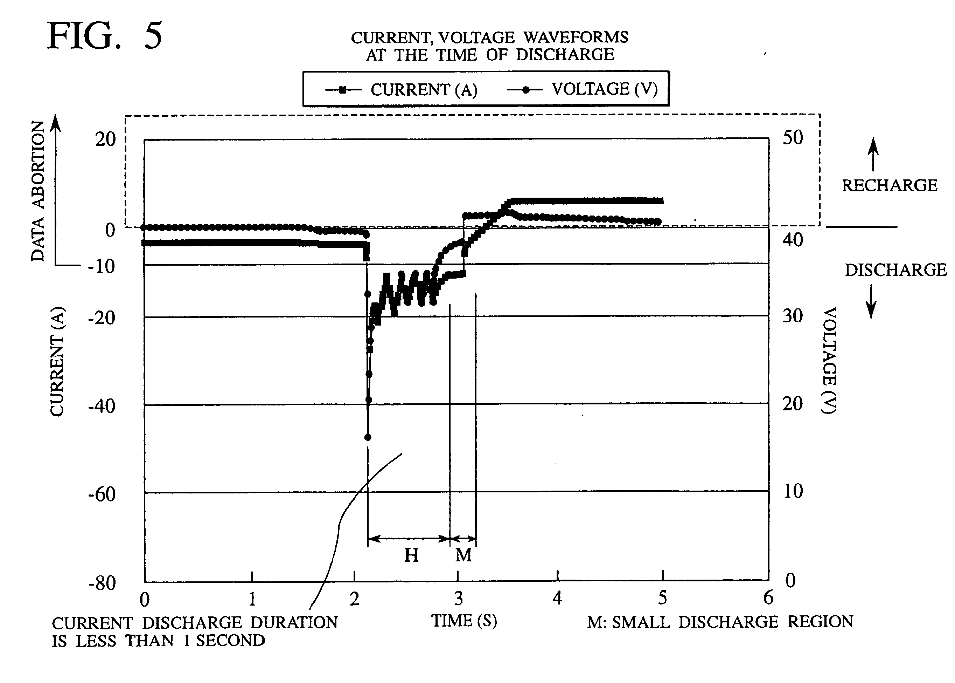

An operation of the battery controller 1 having such a structure will be described below. Figs.2, 3 are flow charts for explaining an operation of the remaining capacity measuring apparatus. Fig.4 is a waveform diagram obtained by measuring a recharge/discharge pattern of the battery 3 connected to the hybrid mechanism portion 31 shown in Fig.1 for a long hour. Fig.5 is an enlarged waveform diagram in which a discharge portion of the waveform of Fig.4 is magnified.

First, the reason why N1 is set to 1 and the reason why N2 is variable will be described. Because a traveling of the hybrid car is assisted by an engine 9 and a motor/generator 10, an electric power from the battery 3 is supplied to the motor/generator 10 or an electric power from the motor/generator 10 is recharged to the battery during a traveling by the engine.

Thus, as shown in Fig.4, recharge and discharge are repeated frequently during a traveling of the hybrid car.

As indicated in Fig.5 by enlarging part of Fig. 4, the discharge is continued for at shortest about 1 second (more specifically, 800 milliseconds).

However, the discharging time is not always about 1 second (a duration time in which less than -10A continues) depending on the kind of the motor which is a load. The discharge time may be shorter or longer depending on the case. Therefore, N1 is set to 1 so that even when the kind of the load is changed, the discharge time (a duration time in which less than -10A continues) from the battery can be always detected depending on the characteristic of the load (e.g., motor).

When the quantity N2 for square sum and product sum of current and voltage is a value corresponding to a time in which the discharge current is below a predetermined value, the remaining capacity can be measured by using current value and voltage value to a full extent in a discharging period which changes depending on the kind of the load.

As shown in Fig.2, the remaining capacity measuring apparatus 23 carries out initial setting for setting the counter N1 to "0", the maximum value of N2 to "10000", the minimum value of N2 to "100" and the like (S201).

The aforementioned load operation signal is outputted when for example, an operating amount of an accelerator, speed pulse amount, wiper rotation amount or the like exceeds a predetermined level or an air-conditioner compressor or the like is carrying out switching operation.

Next, whether or not 1 millisecond has passed is determined (S203). When it is determined that 1 millisecond has passed in step S203, current I and voltage V of the battery 3 from the current sensor 4 and voltage sensor 5 are sampled (S205).

Then, the counter N1 is updated (S207) and whether or not this counter N1 is "1" is determined (S209). When the counter N1 is "1" in step S209, current I and time T are integrated in step S205 so as to obtain a discharge amount and a recharge amount until this time (S211). For example, when current from the battery 3 is discharged to the motor/generator 10, this current is discharge current and therefore, discharge amount is applied in step S211. When the vehicle travels by means of the engine 9, current from the motor/generator 10 is recharged and therefore, recharge amount is applied in step S211.

Next, which a current integrated value obtained in step S211 is discharge side or recharge side is determined (S213). Which the discharge side or recharge side is determined depending on whether current is less than 0 or more than 0 as shown in Figs.4 and 5.

When it is determined that the current integrated value is recharge side in step S213, sampled current I and voltage V are aborted (S239) and the processing is returned to step S201

When it is determined that the current integrated value is discharge side in step S213, whether or not current in step S205 is less than -10A is determined (S215).

When it is determined that the current is less than -10A (-10A, -20A, -30A ...) in step S215, the remaining capacity measuring apparatus 23 updates the counter N2 (S217) and posts a N2 operation flag f indicating that the counter N2 is operating (S219). Then, the processing is returned to step S201.

On the other hand, when it is determined that the discharge current is not less than -10A in step S215, that current is determined to be not suitable for the aforementioned current value condition (a discharge current of a certain magnitude which does not generate an error) (S227) and the current I and voltage V are aborted (S231). Then, whether or not the flag **f** indicating that the counter N2 is operating is posted is determined (S233). When the flag **f** is posted, updating of the counter N2 is stopped (S235).

That is, because recharge condition is changed to discharge condition (less than -10A) and after a while, that discharge condition is changed to recharge condition as shown in Fig.5, N2 is secured as a number corresponding to a time in which the discharge current is less than a predetermined value (corresponding to H in Fig. 5). Therefore, updating of the counter is stopped at this stage.

Next, whether or not a value in the counter N2 is larger than a maximum value ("10000") set in step S201 is determined (S241).

When the value of the counter N2 is determined to be larger than "10000" in step S241, data collected up to then is aborted (S245), the counter N2 is cleared (S247) and the processing is returned to step S201.

Even when discharge current is continued for a long hour depending on the kind of a load on the vehicle (for example, motor), the remaining capacity has to be measured in an appropriate time interval. Thus, the maximum value is set to 10000 (corresponding to 10 seconds).

When the value of the counter N2 is determined to be less than "10000" in step S241, whether or not it is smaller than a minimum value ("100") set in step S201 is determined (S243).

When the value of the counter N2 is determined to be smaller than "100" in step S243, data collected up to then is aborted (S245), the counter N2 is cleared (S247) and the processing is returned to step S201.

Because when the quantity of data is small, it is estimated that an accuracy of a computed remaining capacity drops, the minimum value of N2 is set to 100 (corresponding to 100 milliseconds).

Then, when the value of the counter N2 is determined to be more than "100" in step S243, the processing advances to step S301.

When the processing advances to step S301, it comes that current value and voltage value during an interval in which the discharge current satisfies a predetermined condition (less than -10A) are secured. In a time in which the discharge current satisfied a predetermined condition (less than -10A), the current value and voltage value change depending on the characteristic of a load. Therefore, a preferable number of pairs of the current value and voltage value, preferable for the characteristic of the load, are obtained, the preferable number depending the characteristic of the load.

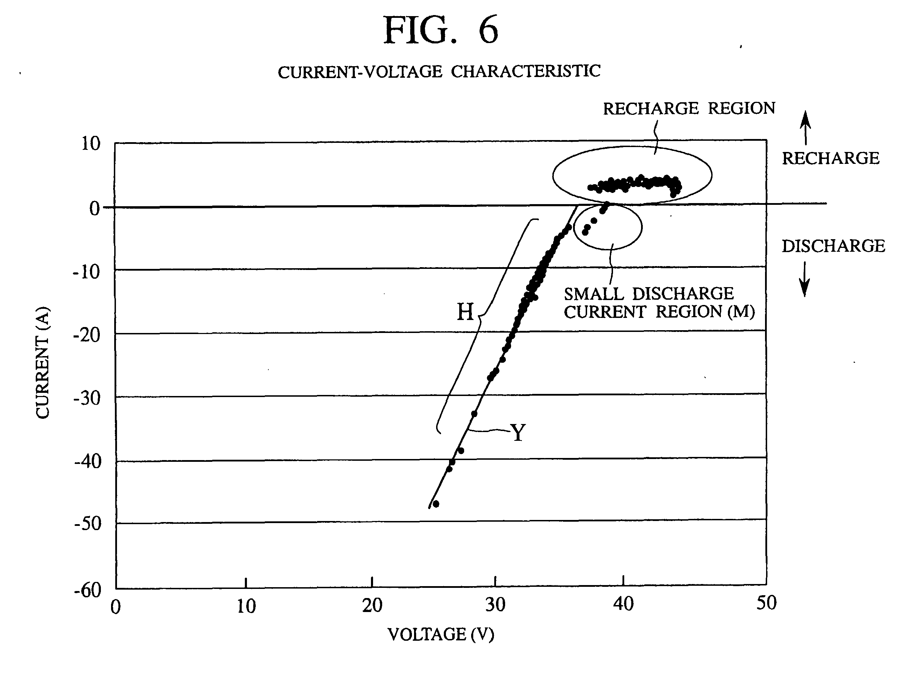

The plural pairs of the current values and voltage values obtained at this time are plotted on the current-voltage coordinate system as shown in Fig.6. This Figure shows a dispersion of current to voltage data. In Fig.6, current is expressed on the ordinate and voltage is expressed on the abscissa.

Although Fig.6 indicates that there are a small discharge current region M and a large discharge current region H, the small discharge current region M (section of less than -10A) is not employed as data in processing of this embodiment and only data of the large discharge current region H (section of less than -10A shown in Fig. 5) is used.

That is, an accurate approximate line can be obtained using the data of this large current region H.

In step S301, a value of the counter N2 is read (S301) and each square sum and product sum are obtained as shown in the equation (1) (S303).

$$S(YY) = \Sigma Y^2 - (\Sigma Y)^2/N2$$
$$S(XX) = \Sigma X^2 - (\Sigma X)^2/N2$$
$$S(XY) = \Sigma XY - (\Sigma X)(\Sigma X)/N2$$

$$\cdots (1)$$

Next, as shown in Fig.3, the remaining capacity measuring apparatus 23 obtains a correlation coefficient **r** using data obtained in step S303 based on the equation (2) (S305).

$$r = \frac{S(XY)}{\sqrt{S(XX)S(XY)}} \qquad \cdots (2)$$

By comparing this correlation coefficient **r** with a preliminarily set up reference correlation coefficient $\mathbf{r_s}$, whether or not the correlation coefficient **r** indicates a strong negative correlation is determined (S307).

When it is determined that the correlation is low in step S307, the sampled current data and voltage data and average data are aborted (S321).

Then, when it is determined that a strong negative correlation is indicated in step S307, current-voltage approximate linear function (V = a · I + b) is obtained based on the equation (3) according to least square method (S309)

$$V = a \cdot I + b$$
$$b = S(XY)/S(YY)$$
$$a = X - b \cdot Y$$

$$\cdots (3)$$

Next, by substituting virtual current value Is (for example, -10A) for the equation (3), a current voltage of the battery 3 is estimated (S311) and a remaining capacity SOC is obtained according to the equation (4) (S313). Then, an output processing for sending this remaining capacity SOC to a display unit is carried out (S315).

$$SOC = \{(Vn^2 - Ve^2)/(Vs^2 - Ve^2)\} \times 100 \qquad \cdots (4)$$

where:

Vs: fully charged voltage
Vn: estimated voltage
Ve: discharge termination voltage

Next, whether or not the obtained remaining capacity SOC is 0% is determined (S317). When the remaining capacity SOC is 0%, this processing is terminated. When the remaining capacity is more than 0%, the counter N2 is cleared (S319) and the processing is returned to step S201 and sampling is carried out every 1 millisecond to perform the above processing again.

Although in the above embodiment, the remaining capacity of the battery 3 connected to the hybrid mechanism portion 31 is obtained, it is permissible to obtain the remaining capacity of the battery 14 provided in a low voltage portion.

When a cell motor of the wiper 19, power window 20, air conditioner 21 is rotating or a head lamp, rear defogger or the like (not shown) is turned on, current flows from the battery and then, the remaining capacity measuring apparatus 1 of this embodiment measures a remaining capacity at that time.

Therefore, although, conventionally, the remaining capacity measuring apparatus is restricted to measurement of the remaining capacity of a battery of an electric vehicle whose battery discharge is relatively long hour, the apparatus described above is suitable for measurement of the remaining capacity of a battery whose recharge/discharge is carried out frequently, like a hybrid car (including a high voltage vehicle) under development in recent years.

As described above, the approximate line is computed according to only current value data and voltage value data obtained during a period in which, with the battery in a discharging condition, its discharging current is over a reference current level. The above period changes depending on the kind of the load. Therefore, even when the load changes, an accurate battery remaining capacity can be estimated correspondingly.

Particularly when the remaining capacity measuring apparatus is employed in the hybrid mechanism portion in which recharge and discharge are repeated frequently, even when the kind of the motor in the hybrid mechanism portion, which is a load is changed, the remaining capacity can be measured using only current value data and voltage value data in a discharging time corresponding to the motor characteristic.

It should be understood that many modifications and adaptations of the invention will become apparent to those skilled in the art and it is intended to encompass such obvious modifications and changes in the scope of the claims appended hereto.


## Claims

1. A battery remaining capacity measuring apparatus comprising:

   a voltage sensor (5) for detecting a terminal voltage of a battery (3) connected to a load;
   a current sensor (4) for detecting a current flowing from the battery (3) to the load;
   a collecting means (23) for collecting a voltage value detected by the voltage sensor (5) and a current value detected by the current sensor (4) every predetermined time interval;
   an obtaining means (23) for obtaining plural pairs of voltage values and current values collected by the collecting means in a period in which the battery is continuously discharged, wherein the obtaining means continues to obtain a pair of voltage value and current value when the current value indicates that the battery is in discharging condition and the current value is more than a predetermined value, but stops obtaining the pair of -voltage value and current value when otherwise;
   a computing means (23) for computing a sample correlation coefficient between voltage and current based on the plural pairs of voltage values and current values obtained by the obtaining means (23), wherein the computing means is configured to compute an approximate line using current-voltage coordinates based on the plural pairs of the voltage values and the current values when the correlation coefficient indicates that a predetermined degree of correlation is exceeded; and
   an estimating means (23) for estimating a remaining capacity of the battery by obtaining a corresponding voltage value based on the approximate line and a preliminarily set current value.

2. A battery remaining capacity measuring apparatus according to claim 1 wherein when the quantity of plural pairs of voltage value and current value collected in a period in which the battery is continuously discharged is larger than a maximum value or smaller than a predetermined minimum value, the obtaining means (23) aborts the obtained plural pairs of voltage value and current value.

3. A battery remaining capacity measuring apparatus according to claim 1 wherein the load is a hybrid mechanism (31) for assisting travel, comprising an engine (9) and a motor (10), and the battery (3) is electrically connected to the motor (10).

4. A battery remaining capacity measuring apparatus according to claim 1 wherein the predetermined value is 10 ampere.


## Patentansprüche

1. Messgerät für eine verbleibende Kapazität einer Batterie mit:

   einem Spannungssensor (5) zum Detektieren einer Anschlussspannung (3), die mit einer Last verbunden ist;
   einem Stromsensor (4) zum Detektieren eines Stroms, der von der Batterie (3) zu der Last fließt;
   einer sammelnde Vorrichtung (23) zum Sammeln eines Spannungswertes, der von dem Spannungssensor (5) detektiert wird und eines Stromwertes, der von dem Stromsensor (4) detektiert wird, jedes vorbestimmte Zeitintervall;
   einer erhaltende Vorrichtung (23) zum Erhalten vieler Paare von Spannungswerten und Stromwerten, die von der sammelnden Vorrichtung in einem Zeitraum gesammelt werden, in dem die Batterie kontinuierlich entladen wird, wobei die erhaltende Vorrichtung fortfährt, ein Paar eines Spannungswertes und Stromwertes zu erhalten, wenn der Stromwert anzeigt, dass die Batterie in einer entladenden Bedingung ist und der Stromwert mehr als ein vorbestimmter Wert ist, jedoch ansonsten ein Erhalten des Paares eines Spannungswertes und Stromwertes stoppt;

einer berechnenden Vorrichtung (23) zum Berechnen eines Proben-Korrelationskoeffizienten zwischen Strom und Spannung basierend auf den vielen Paaren von Spannungswerten und Stromwerten, die durch die erhaltende Vorrichtungen (23) erhalten werden, wobei

die berechnende Vorrichtung konfiguriert ist, eine annähernde Gerade unter Verwendung der Strom-Spannungs-Koordinaten basierend auf den vielen Paaren von Spannungswerten und Stromwerten zu berechnen, wenn der Korrelationskoeffizient anzeigt, dass ein vorbestimmter Grad einer Korrelation überschritten wird; und eine schätzende Vorrichtung (23) zum Schätzen einer verbleibenden Kapazität der Batterie durch Erhalten eines entsprechenden Spannungswertes, der auf der annähernden Linie und einem vorläufig gesetzten Stromwert basiert.

2.  Messgerät für eine verbleibende Kapazität einer Batterie nach Anspruch 1, wobei, wenn die Menge an vielen Paaren eines Spannungswertes und Stromwertes, die in einem Zeitraum gesammelt werden, in dem die Batterie kontinuierlich entladen wird, größer als ein Maximalwert oder kleiner als ein vorbestimmter Minimalwert ist, die erhaltende Vorrichtung (23) die erhaltenen, vielen Paare eines Spannungswertes und Stromwertes abbricht.

3.  Messgerät für eine verbleibende Kapazität einer Batterie nach Anspruch 1, wobei die Last ein hybrider Mechanismus (31) zum Assistieren einer Reise ist, mit einer Maschine (9) und einem Motor (10) und die Batterie (3) elektrisch mit dem Motor (10) verbunden ist.

4.  Messgerät für eine verbleibende Kapazität einer Batterie nach Anspruch 1, wobei der vorbestimmte Wert 10 Ampere beträgt.


**Revendications**

1.  Appareil de mesure de la capacité résiduelle d'une batterie comprenant :

    un capteur de tension (5) pour détecter une tension aux bornes d'une batterie (3) reliée à une charge ;
    un capteur de courant (4) pour détecter un courant circulant de la batterie (3) vers la charge ;
    un moyen collecteur (23) pour collecter une valeur de tension détectée par le capteur de tension (5) et une valeur de courant détectée par le capteur de courant (4) tous les intervalles de temps prédéterminés ;
    un moyen d'obtention (23) pour obtenir plusieurs paires de valeurs de tension et de valeurs de courant recueillies par le moyen collecteur dans une période où la batterie est déchargée de manière continue, dans lequel le moyen d'obtention continue à obtenir une paire de valeur de tension et de valeur de courant si la valeur de courant indique que la batterie est en état de décharge et la valeur du courant est supérieure à une valeur prédéterminée, mais cesse d'obtenir la paire de valeur de tension et de valeur de courant s'il en est autrement ;
    un moyen calculateur (23) pour calculer un coefficient de corrélation d'échantillons entre la tension et le courant en se basant sur les plusieurs paires de valeurs de tension et de valeurs de courant obtenues par le moyen d'obtention (23), dans lequel
    le moyen calculateur est configuré pour calculer une ligne approchée en utilisant les coordonnées courant-tension basées sur les plusieurs paires de valeurs de tension et de valeurs de courant lorsque le coefficient de corrélation indique qu'un degré prédéterminé de corrélation est dépassé ; et
    un moyen d'estimation (23) pour estimer la capacité résiduelle de la batterie en obtenant une valeur de tension correspondante en se basant sur la ligne approchée et une valeur de courant fixée préalablement.

2.  Appareil de mesure de la capacité résiduelle d'une batterie selon la revendication 1 dans lequel lorsque la quantité des plusieurs paires de valeurs de tension et de valeurs de courant recueillies dans la période où la batterie se décharge de manière continue est supérieure à une valeur maximale ou inférieure à une valeur minimale prédéterminée, le moyen d'obtention (23) abandonne les plusieurs paires obtenues de valeurs de tension et de valeur de courant.

3.  Appareil de mesure de la capacité résiduelle d'une batterie selon la revendication 1 dans lequel la charge est un mécanisme hybride (31) d'assistance au déplacement, comprenant un moteur à combustion (9) et un moteur électrique (10), et la batterie (3) est reliée électriquement au moteur électrique (10).

**4.** Appareil de mesure de la capacité résiduelle d'une batterie selon la revendication 1 dans lequel la valeur prédéterminée est de 10 ampères.

FIG. 1

EP 1 055 934 B1

# FIG. 2

START

S201 — INITIAL SETTING
N1=0
N2max=10000
N2min=100

S203 — 1 milli second HAS PASSED ?  — NO

YES

S205 — DATA SAMPLING
CURRENT(i)
VOLTAGE DATA (v)

S207 — UPDATE N1

S209 — N1=1 ? — NO

YES

S239 — ABORT CURRENT I, V

S211 — INTEGRATE CURRENT
(RECHARGE, DISCHARGE)

S213 — CURRENT IS ON
DISCHARGE SIDE OR
RECHARGE SIDE? — RECHARGE SIDE

DISCHARGE SIDE

S215 — DISCHARGING
CURRENT IS
LESS THAN -10A? — NO

YES

S227 — DOES NOT CONFORM
TO CURRENT VALUE
CONDITION

S217 — UPDATE COUNTER N2
(N2=N2+1)

S231 — ABORT CURRENT I, V

S219 — POST N2 OPERATION
FLAG f

S233 — f EXISTS ? — NO

YES

S235 — STOP UPDATING OF N2

S241 — N2>N2max ? — YES

NO

3

S243 — N2<N2min ? — YES

NO

S245 — ABORT DATA

S247 — CLEAR N2

1

# FIG. 3

S301 — **READ N2** ① (input)

S301 — **CLEAR N2** ← ② ③ (output)

S303 —
**COMPUTE EACH SQUARE SUM AND PRODUCT SUM**

$$S(YY)=\Sigma Y^2 -(\Sigma Y)^2/N2$$
$$S(XX)=\Sigma Y^2 -(\Sigma X)^2/N2$$
$$S(XY)=\Sigma XY-(\Sigma X)(\Sigma Y)/N2$$

S305 —
**COMPUTE CORRELATION COEFFICIENT**

$$r=S(XY)/\sqrt{S(XX)S(YY)}$$

S321 — **ABORT DATA** ← NO ← S307 **NEGATIVE CORRELATION IS STRONG ? $r \leqq r_s$ ?**

② (from ABORT DATA)

YES

S309 —
**REGRESSION ANALYSIS BY LEAST SQUARE METHOD**
COMPUTE COEFFICIENT a, b OF $V = a \cdot I+b$
$$b=S(XY)/S(YY)$$
$$a=X-b \cdot Y$$

S311 —
**COMPUTE ESTIMATED VOLTAGE Vn**

SUBSTITUTE A VIRTUAL CURRENT VALUE $I = Is$
ESTIMATED VOLTAGE $Vn = a \cdot Is+b$

S313 —
**COMPUTE REMAINING CAPACITY SOC(%)**

$$SOC= \{ (Vn^2 -Ve^2)/(Vs^2 -Ve^2) \} \times 100$$

S315 — **OUTPUT PROCESSING**

S317 — **SOC = 0(%) ?** — NO

YES

**END**

# FIG. 4

# FIG. 5

CURRENT, VOLTAGE WAVEFORMS
AT THE TIME OF DISCHARGE

— ■ — CURRENT (A)    — ● — VOLTAGE (V)

CURRENT DISCHARGE DURATION
IS LESS THAN 1 SECOND

TIME (S)

M: SMALL DISCHARGE REGION

EP 1 055 934 B1

# FIG. 6

## CURRENT-VOLTAGE CHARACTERISTIC

RECHARGE REGION

RECHARGE

DISCHARGE

SMALL DISCHARGE
CURRENT REGION (M)

H

Y

CURRENT (A)

VOLTAGE (V)

EP 1 055 934 B1

# FIG. 7

EP 1 055 934 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5698983 A